# EUROPEAN PATENT SPECIFICATION

(11) **EP 2 940 868 B1**
(45) Date of publication and mention of the grant of the patent: **30.12.2020**
(21) Application number: 13869831.1
(22) Date of filing: 11.09.2013
(51) Int. Cl.: H03K 17/60, H03K 17/00, H03K 17/78, H03K 17/18, H05B 45/44, H03K 17/74

(54) **POWER SUPPLY CIRCUIT AND SENSING CIRCUIT**
STROMVERSORGUNGSSCHALTUNG UND MESSSCHALTUNG
CIRCUIT D'ALIMENTATION ÉLECTRIQUE ET CIRCUIT DE DÉTECTION

(30) Priority: 28.12.2012 JP 2012288499
(43) Date of publication of application: 04.11.2015
(73) Proprietor: Honda Motor Co., Ltd., Minato-ku Tokyo 107-8556 (JP)
(72) Inventor: TSUCHIYA, Yosuke, Wako-shi Saitama 351-0193 (JP); ISHII, Norihisa, Wako-shi Saitama 351-0193 (JP)
(74) Representative: Beder, Jens
(86) International application number: PCT/JP2013/005381
(87) International publication number: WO 2014/103103

(56) References cited:
- JP-A- H 077 401
- JP-A- H02 119 420
- JP-A- H03 184 409
- JP-A- H06 177 726
- JP-A- S62 109 408
- US-A1- 2011 058 297

## Description

### TECHNICAL FIELD

The present invention relates to a power supply circuit for supplying electric power to a load, and a detection circuit for detecting the open and close state of a switch.

### BACKGROUND ART

In Japanese Patent Laid-Open No. 2008-213813, There is disclosed a lighting circuit that uses a divided potential obtained by dividing the electric potential on the downstream side of a switch to drive a switching element, and sets a voltage divider so as to make the driving voltage lower than the minimum driving voltage of the switching element when the electric potential on the downstream side is equal to or lower than a predetermined potential, thereby prohibiting a light-emitting element from lighting even when an electric potential lower than the predetermined potential occurs on the downstream side due to a leakage current.

However, the leakage current increases depending on the voltage between the switch terminals. For this reason, even if the switch is off, the light-emitting element may erroneously light if the leakage current increases to a predetermined value or more.

There are various kinds of switches. Since the structure of the contact points differs between the switches, some switches readily generate a leakage current. To prevent malfunction of a load, the switch that can be used is limited.

Document JP H02 119420 (A) discloses a light emitting diode LED connected in series with a diode D1 via one switching means q23 of two switching means q22, q23. The LED is lighted at a stable output. A constant current circuit 3 is provided between the light emitting diode LED and circuit ground GND. A voltage drop, when the changeover switch SW provided in parallel with the diode D1 is closed, is detected to invert the blink of the light emitting diode LED for the operation display. Thus, the stable display output and the operation-switching signal of light-on/dark-on of the operation display light are given through one common wire, thereby decreasing number of terminals.

### SUMMARY OF INVENTION

### TECHNICAL PROBLEM

It is an object of the present invention to prevent malfunction of a load caused by a leakage current in a switch in a open state.

It is another object of the present invention to prevent the influence of a leakage current in a switch in a open state and correctly detect the open and close state of the switch.

### SOLUTION TO PROBLEM

In order to achieve the above-described objects, the present invention comprises the following arrangement.

According to the present invention, there is provided a detection circuit for detecting an open and close state of a switch, the detection circuit comprising:
a first resistor and a first p-n junction element, which are connected in series with a power supply; a switch connected in parallel to the first p-n junction element; a second resistor and a second p-n junction element, which are connected in series with the power supply; and a comparison means for outputting an opening/closing signal representing the open and close state of the switch, wherein said comparison means is configured to compare a voltage of a first connection point with a voltage of a second connection point to output the opening/closing signal. The first and the second p-n junction element are connected in a forward direction with regard to a voltage of the power supply. At the first connection point, the first resistor, the first p-n junction element and the switch are connected. At the second connection point, the second resistor and the second p-n junction element are connected. A forward drop voltage of the second p-n junction element is smaller than a forward drop voltage of the first p-n junction element.
In the detection circuit according to an embodiment, the second p-n junction element comprises a diode, and the first p-n junction element comprises a plurality of diodes, which are connected in series.

A power supply circuit having a driving means for supplying electric power to a load when a driving signal is input, may comprise: driving signal generation means having a resistor and a p-n junction connected in series with a power supply; and a switch connected in parallel to the p-n junction, wherein the p-n junction is connected in a forward direction with respect to a voltage of the power supply, and the generation means outputs the driving signal to the driving means when the switch is in a close state.

The relationship among a resistance R_{Leak} corresponding to a leakage current occurred in the switch in an open state of the switch, the voltage Vcc of the power supply, a forward drop voltage V of the p-n junction, and a resistance value R1 of the resistor meets R1 > (Vcc/V - 1)·R_{Leak}.

In the power supply circuit, even if a leakage occurs in the switch, the upper limit voltage applied to the switch is limited to the saturation voltage of the p-n junction and is almost constant. For this reason, the leakage current never increases excessively, and malfunction of the load caused by the leakage current can be prevented. In particular, a lighting error of an LED lighting device that lights due to a slight leakage current can be prevented.

In addition, it is possible to prevent an excessive voltage (for example, if the load is an LED, a voltage more than the threshold voltage of the lighting signal) from being applied to the generation means of driving signal, and reliably prevent power supply to the load caused by the leakage current.

According to the detection circuit of the present invention, it is possible to prevent the influence of the leakage current in the switch in an open state, and correctly detect the open and close state of the switch.

Other features and advantages of the present invention will be apparent from the following descriptions taken in conjunction with the accompanying drawings, in which like reference characters designate the same or similar parts throughout the figures thereof.

### BRIEF DESCRIPTION OF DRAWINGS

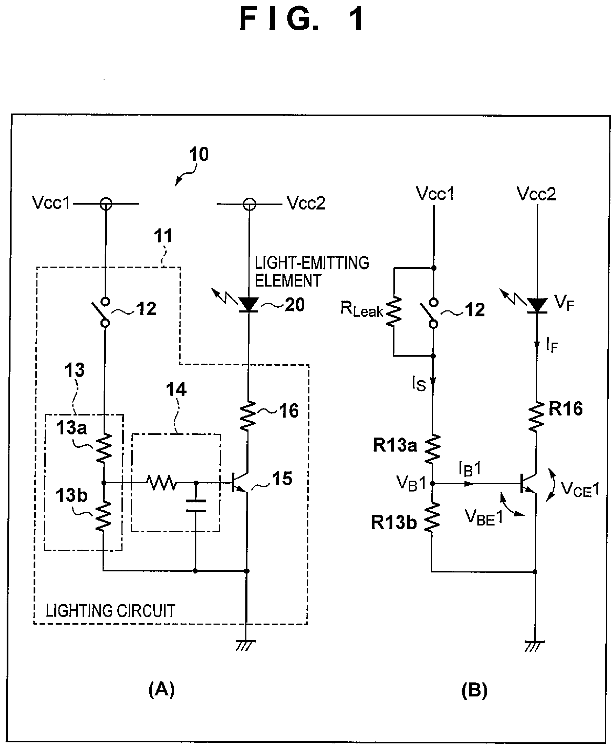

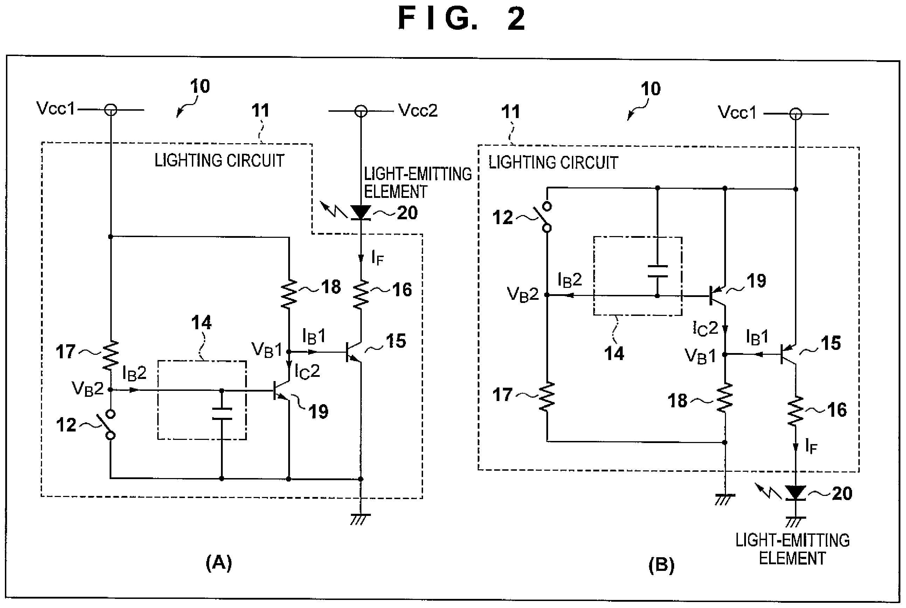

The accompanying drawings, which are incorporated in and constitute a part of the specification, illustrate embodiments of the invention and, together with the description, serve to explain the principles of the invention. Figs. 1 and 2 describe power supply circuits, which do not form part of the invention defined in the claims, but which represent background art that is useful for understanding the invention.
[Fig. 1] Fig. 1A is a circuit diagram showing the outline of a power supply circuit comprising a light-emitting element and a light-emitting element lighting circuit. Fig. 1B is a circuit diagram for explaining an applied voltage between the base electrode and the emitter electrode of a switching element when a leakage current occurs.
[Fig. 2] Fig. 2A is a circuit diagram showing the arrangement of a power supply circuit according to the first embodiment in which an npn transistor is used as a switching element. Fig. 2B is a circuit diagram showing the arrangement of the power supply circuit according to the first embodiment in which a pnp transistor is used as a switching element.

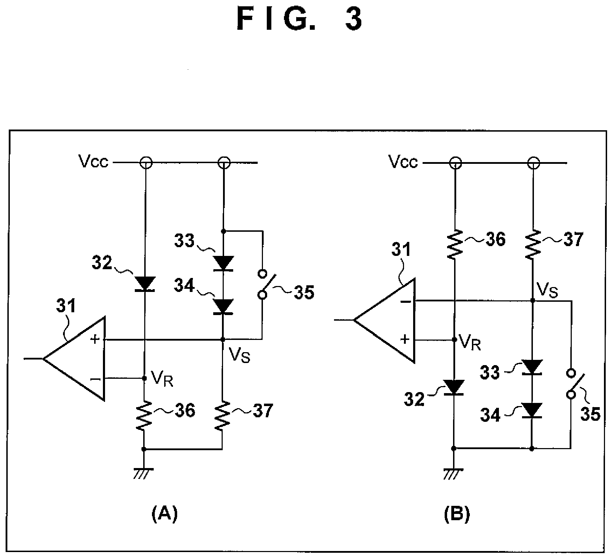

[Fig. 3] Fig. 3A is a circuit diagram showing the arrangement of a detection circuit for detecting the open and close state of a switch according to the second embodiment in which diodes and a switch are disposed on the power supply voltage side. Fig. 3B is a circuit diagram showing the arrangement of the detection circuit for detecting the open and close state of a switch according to the second embodiment in which diodes and a switch are disposed on the ground potential side.

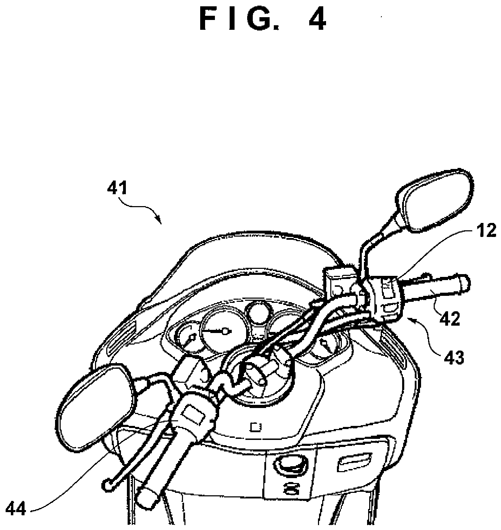

[Fig. 4] Fig. 4 is a view showing the disposition of a switch that turns on/off a light-emitting element.

### DESCRIPTION OF THE FIGURES

A power supply circuit and a detection circuit according to Fig. 1 represent background art that is useful for understanding the invention.. The power supply circuit and the detection circuit will now be described in detail with reference to the accompanying drawings. Note that a power supply circuit and a detection circuit configured to control the emission/non-emission state of a light-emitting element such as a light-emitting diode (LED) serving as a load will be described below as an example. However, when an malfunction caused by a leakage current in a switch in an open state (to be sometimes simply referred to as a "leakage current" hereinafter) is problematic, the present invention is applicable to a power supply circuit for supplying electric power to the load or a detection circuit for detecting the on/off operation of power supply to the load. The load to which the power supply circuit supplies electric power comprises a motor, a relay, a solenoid, and various kinds of electronic equipment.

Fig. 1A is a circuit diagram showing the outline of a power supply circuit 10 comprising a light-emitting element 20 and a light-emitting element lighting circuit 11.

Referring to Fig. 1A, a switch 12 is a switch, for example, a toggle switch or a slide switch for an electronic device, which mechanically sets electric contact points to a contact state or noncontact state in accordance with a human operation and maintains the state.

When the switch 12 is in the open state, no electric power is supplied to the light-emitting element lighting circuit 11, the current path from the collector electrode to the emitter electrode (to be referred to as a "CE path" hereinafter) of a switching element 15 is nonconductive (to be referred to as "off" hereinafter), and the light-emitting element 20 is in a non-emission state. When the switch 12 turns to a close state, a base current I_{B}1 is supplied to the base electrode of the switching element 15 through a voltage divider 13 and a low-pass filter 14, and the CE path is rendered conductive (to be referred to as "on" hereinafter). That is, when the switch 12 turns to the close state, the light-emitting element 20 is driven by a current I_{F} whose current value is limited by a resistor 16, and turns to an emission state.

When a leakage current is occurred in the switch 12 in the open state, a voltage is applied to the voltage divider 13. Fig. 1B is a circuit diagram for explaining a voltage V_{B}1 applied to the current path from the base electrode to the emitter electrode of the switching element 15 (to be referred to as a "BE path" hereinafter) when a leakage current is occurred. Referring to Fig. 1B, a resistance R_{Leak} illustrated in parallel to the switch 12 in Fig. 1B is an equivalent resistance representing a leakage current (to be referred to as a "leakage resistance" hereinafter). In this case, the voltage V_{B}1 is given by ${V}_{B} 1 = Vcc 1 ⋅ R 13 b / \left({R}_{Leak}+R13a+R13b\right)$ (1) where
Vcc1 is the power supply voltage,
R13a is the resistance value of a resistor 13a,
R13b is the resistance value of a resistor 13b

If the voltage V_{B}1 meets equation (2), the switching element 15 is turned on, and the light-emitting element 20 emits light. If equation (2) is not met, the switching element 15 is not turned on, and the light-emitting element 20 does not emit light. ${V}_{B} 1 > {V}_{BE} 1$ (2) where V_{BE}1 is the base-emitter voltage based on the internal potential of the p-n junction of the switching element 15 (0.6 to 0.7 V).

However, the characteristic of the switching element 15 including V_{BE}1 varies due to various factors. In addition, there exists a switch that readily occurs a leakage current, and the leakage current increases depending on the voltage between the switch terminals. In the power supply circuit 10 shown in Fig. 1A, Vcc1 (for example, 12 V) is applied between the switch terminals of the switch 12 in the open state. Hence, the light-emitting element 20 may emit light or unstably repeat emission and non-emission due to the leakage current. That is, erroneous lighting may occur in which the light-emitting element 20 erroneously emits light regardless of the open state of the switch 12.

Fig. 4 is a view showing the disposition of the switch 12 that turns on/off the light-emitting element 20. The switch 12 is disposed at a position where the rider of a motorcycle 41 can easily turns on/off a lighting device including the light-emitting element 20, for example, in a switch box 43 of a handle bar 42 of the motorcycle 41. Note that although Fig. 4 shows an example in which the switch 12 is disposed in the switch box 43 on the right side of the handle bar 42, the switch 12 may be disposed in a switch box 44 on the left side of the handle bar 42.

Note that although Fig. 4 illustrates an example of the motorcycle 41, the present invention is also applicable to an open motor tricycle, a four-wheel vehicle, an all-terrain vehicle (ATV), and the like.

Figs. 2A and 2B are circuit diagrams showing the arrangement of a power supply circuit 10, that represents background art useful for understanding the invention. Note that Fig. 2A shows an arrangement in which an npn transistor is used in a switching element, and Fig. 2B shows an arrangement in which a pnp transistor is used in a switching element. Note that the same reference numerals as in Figs. 1A and 1B denote the same parts, and a detailed description thereof will be omitted.

First, the operation of the power supply circuit 10 shown in Fig. 2A will be described. A switching element 19 generates a driving signal of a switching element 15 based on the open and close state of a switch 12. That is, when the switch 12 is in the open state, a base current I_{B}2 flows to the switching element 19 through a resistor 17 and a low-pass filter 14, and the switching element 19 is on. Hence, a collector current I_{C}2 flows to the CE path of the switching element 19 through a resistor 18. As a result, a base voltage V_{B}1 (driving signal) of the switching element 15 is much lower than V_{BE}1 (V_{B}1 < V_{BE}1). That is, when the switch 12 is in the open state, the switching element 15 is off, and a light-emitting element 20 is in a non-emission state.

On the other hand, when the switch 12 is in the close state, a base voltage V_{B}2 of the switching element 19 is almost the ground potential (0 V), and the switching element 19 is off (that is, the CE path is nonconductive). As a result, the base voltage V_{B}1 (driving signal) of the switching element 15 meets the condition (V_{B}1 > V_{BE}1) of equation (2), a base current I_{B}1 flows to the switching element 15 through the resistor 18, and the switching element 15 is on. That is, when the switch 12 is in the close state, the light-emitting element 20 is in the emission state.

In the power supply circuit 10 shown in Fig. 2A, the voltage applied between the switch terminals of the switch 12 in the open state is limited by the p-n junction of the switching element 19 and set to V_{BE}1 (0.6 to 0.7 V). Hence, the voltage applied between the switch terminals of the switch 12 in the open state can be made very small as compared to the power supply circuit 102 shown in Fig. 1A. This makes it possible to suppress the leakage current in the switch 12 and prevent the switching element 19 from being tuned off in the open state of the switch 12. In other words, it is possible to reliably prevent erroneous lighting in which the light-emitting element 20 emits light regardless of the open state of the switch 12

Next, the outline of the operation of the power supply circuit 10 shown in Fig. 2B will be described. When the switch 12 is in the open state, the base current I_{B}2 flows to the switching element 19 through the low-pass filter 14 and the resistor 17, and the switching element 19 is on. Hence, the collector current I_{C}2 flows to the CE path of the switching element 19 through the resistor 18. As a result, the voltage V_{B}1 (driving signal) between a power supply voltage Vcc1 and the base of the switching element 15 is much lower than V_{BE}1 (V_{B}1 < V_{BE}1). That is, when the switch 12 is in the open state, the switching element 15 is off, and the light-emitting element 20 is in the non-emission state.

On the other hand, when the switch 12 is in the close state, the base voltage V_{B}2 of the switching element 19 is almost the power supply voltage Vcc1, and the switching element 19 is off (that is, the CE path is nonconductive). As a result, the base voltage V_{B}1 (driving signal) of the switching element 15 meets the condition (V_{B}1 > V_{BE}1) of equation (2). That is, the base current I_{B}1 flows to the switching element 15 through the resistor 18, and the switching element 15 is on. That is, when the switch 12 is in the close state, the light-emitting element 20 is in the emission state.

As described above, the power supply circuit 10 shown in Fig. 2B is different from the power supply circuit 10 shown in Fig. 2A in that the pnp transistor is used in the switching element. However, the operation is almost the same as that of the power supply circuit 10 shown in Fig. 2A. That is, the power supply circuit 10 shown in Fig. 2B can reliably prevent erroneous lighting of the light-emitting element 20 caused by the leakage current.

Note that the power supply circuit 10 shown in Fig. 2A can separately include the power supply Vcc1 of a light-emitting element lighting circuit 11 and a power supply Vcc2 of the light-emitting element 20. The voltages of these power supplies may be different. On the other hand, in the power supply circuit 10 shown in Fig. 2B, the emitter potentials of the two switching elements 15 and 19 need to match, and the light-emitting element lighting circuit 11 and the light-emitting element 20 need to share a power supply. To use separate power supplies as the power supply of the light-emitting element lighting circuit 11 and the power supply of the light-emitting element 20 in the power supply circuit 10 shown in Fig. 2B, a power supply of a negative voltage is used by performing a positive ground.

Note that Figs. 2A and 2B show circuit examples in which one light-emitting element 20 is caused to emit light. However, the power supply circuits 10 shown in Figs. 2A and 2B are also applicable to control the emission/non-emission state of a light-emitting element array formed by serial-parallel connection of a plurality of light-emitting elements.

### EMBODIMENT OF THE INVENTION

As the embodiment, a detection circuit that suppresses the influence of a leakage current using the internal potential of the above-described p-n junction and correctly detects the open and close state of a switch will be described.

Figs. 3A and 3B are circuit diagrams showing the arrangement of a detection circuit for detecting the open and close state of a switch according to the second embodiment. Fig. 3A shows an example in which an arrangement comprising p-n junction elements (to be referred to as "diodes" hereinafter) 33 and 34 connected in series and a switch 35 connected in parallel is disposed on the power supply voltage side. Fig. 3B shows an example in which the arrangement is disposed on the ground potential side.

First, the operation of the detection circuit shown in Fig. 3A will be described. When the switch 35 is in the open state, the inter-terminal voltage of the switch 35 is limited by a forward drop voltage V_{F} of the diodes. Hence, a voltage V_{S} off input to the non-inverting input terminal (to be referred to as a "positive terminal" hereinafter) of a comparator 31 is given by ${V}_{S} off = Vcc - 2 ⋅ {V}_{F}$ (3) where Vcc is the power supply voltage

When the switch 35 turns to the close state, a voltage V_{S} on input to the positive terminal of the comparator 31 equals to the power supply voltage Vcc. On the other hand, a reference voltage V_{R} input to the inverting input terminal (to be referred to as a "negative terminal" hereinafter) of the comparator 31 is given by ${V}_{R} = Vcc - {V}_{F}$ (4)

The comparator 31 outputs a low-level (referred to as an "L-level" hereinafter) signal when V_{S} ≤ V_{R}, and outputs a high-level (referred to as an "H-level" hereinafter) signal when V_{S} > V_{R}. Hence, when the switch 35 is in the open state (V_{S} off < V_{R}), the comparator 31 outputs an L-level signal (switch opening signal). When the switch 35 is in the close state (V_{S} on > V_{R}), the comparator 31 outputs an H-level signal (switch closing signal) .

Next, the operation of the detection circuit shown in Fig. 3B will be described. When the switch 35 is in the open state, the inter-terminal voltage of the switch 35 is limited by the forward drop voltage V_{F} of the diodes. Hence, the voltage V_{S} off input to the negative terminal of the comparator 31 is given by ${V}_{S} off = 2 ⋅ {V}_{F}$ (5)

When the switch 35 turns to the close state, the voltage V_{S} on input to the negative terminal of the comparator 31 almost equals to the ground potential (0 V). On the other hand, the reference voltage V_{R} input to the positive terminal of the comparator 31 is given by ${V}_{R} = {V}_{F}$ (6)

The comparator 31 outputs an L-level signal when V_{S} ≥ V_{R}, and outputs an H-level signal when V_{S} < V_{R}. Hence, when the switch 35 is in the open state (V_{S} off > V_{R}), the comparator 31 outputs the switch opening signal having L-level. When the switch 35 is in the close state (V_{S} on < V_{R}), the comparator 31 outputs the switch closing signal having H-level.

The output (switch opening/closing signal) from the comparator 31 is supplied to the port of a microprocessor (not shown), and the microprocessor performs various kinds of control (for example, emission/non-emission control of the light-emitting element) in accordance with the open and close state of the switch 35.

As described above, the leakage current increases depending on the inter-terminal voltage of the switch 35. According to the detection circuits shown in Figs. 3A and 3B, the inter-terminal voltage of the switch 35 in the open state is limited to 2V_{F} and falls within the range of 1.2 to 1.4 V. Hence, the leakage current in the switch 35 in the open state can be suppressed very small. It is consequently possible to prevent the influence of the leakage current and correctly detect the open and close state of the switch 35.

Figs. 3A and 3B show examples in which to detect the open and close state of the switch 35 using V_{F} of a diode 32 as the reference voltage, the diodes 33 and 34 connected in series are connected in parallel to the switch 35. However, when a device that generates a reference voltage (for example, 0.3 V) lower than V_{F} is used in place of the diode 32, the number of diodes connected in parallel to the switch 35 can be decreased to one.

Note that a low-pass filter 14 shown in Fig. 2A may be disposed between the connection point of a resistor 37 and the diodes 33 and 34, and the input terminal of the comparator 31 for the purpose of noise elimination. In addition, disposing a capacitor in parallel to a resistor 36 in Fig. 3A or in parallel to the diode 32 in Fig. 3B is also effective to eliminate noise.

As described above, even when a leakage occurs in the switch in the open state, the upper limit of the voltage applied to the switch is limited by the internal potential of the p-n junction and is almost constant. Hence, the leakage current never increases excessively, and malfunction of the load caused by the leakage current can be prevented.

## Claims

1. A detection circuit for detecting an open and close state of a switch, comprising:
a first resistor (37) and a first p-n junction element (33, 34) which are connected in series with a power supply (Vcc);
a switch (35) connected in parallel to the first p-n junction element (33, 34);
a second resistor (36) and a second p-n junction element (32) which are connected in series with the power supply (Vcc); and
comparison means (31) for outputting an opening/closing signal representing the open and close state of the switch (35),
wherein said comparison means (31) is configured to compare a voltage (Vs) of a first connection point with a voltage (VR) of a second connection point to output the opening/closing signal, and
the first and second p-n junction elements are connected in a forward direction with regard to a voltage of the power supply,
wherein
at the first connection point, the first resistor (37), the first p-n junction element (33, 34) and the switch (35) are connected,
at the second connection point, the second resistor (36) and the second p-n junction element (32) are connected, and
a forward drop voltage (V_{F}) of the second p-n junction element (32) is smaller than a forward drop voltage (2V_{F}) of the first p-n junction element (33, 34).

2. The detection circuit according to claim 1, wherein
the second p-n junction element (32) comprises a diode, and
the first p-n junction element (33, 34) comprises a plurality of diodes which are connected in series.

## Patentansprüche

1. Ermittlungsschaltung zum Ermitteln eines offenen und geschlossenen Zustands eines Schalters, aufweisend:
einen ersten Widerstand (37) und ein erstes p-n-Übergang-Element (33, 34), die mit einer Stromversorgung (Vcc) in Reihe geschaltet sind;
einen Schalter (35), der mit dem ersten p-n-Übergang-Element (33, 34) parallel geschaltet ist;
einen zweiten Widerstand (36) und ein zweites p-n-Übergang-Element (32), die mit der Stromversorgung (Vcc) in Reihe geschaltet sind; und
Vergleichsmittel (31) zum Ausgeben eines Öffnungs-/Schließsignals, das den Öffnungs- und Schließzustand des Schalters (35) darstellt,
wobei die Vergleichsmittel (31) so ausgebildet sind, dass sie eine Spannung (Vs) eines ersten Anschlußpunktes mit einer Spannung (VR) eines zweiten Anschlusspunktes vergleichen, um das Öffnungs-/Schließsignal auszugeben, und
das erste und das zweite p-n-Übergang-Element in Bezug auf eine Spannung der Stromversorgung in Vorwärtsrichtung verbunden sind,
wobei
am ersten Anschlusspunkt der erste Widerstand (37), das erste p-n-Übergang-Element (33, 34) und der Schalter (35) angeschlossen sind,
am zweiten Anschlusspunkt der zweite Widerstand (37) und das zweite p-n-Übergang-Element (33, 34) angeschlossen sind, und
eine Vorwärtsabfallspannung (V_{F}) des zweiten p-n-Übergang-Elements (32) kleiner ist als eine Vorwärtsabfallspannung (2V_{F}) des ersten p p-n-Übergang-Elements (33, 34).

2. Ermittlungsschaltung nach Anspruch 1, wobei
das zweite p p-n-Übergang-Element (32) eine Diode umfasst, und
das erste p-n-Übergang-Element (33, 34) aus einer Mehrzahl von Dioden besteht, die in Reihe geschaltet sind.

## Revendications

1. Circuit de détection pour détecter un état ouvert et fermé d'un commutateur, comprenant :
une première résistance (37) et un premier élément de jonction p-n (33, 34) qui sont connectés en série avec un bloc d'alimentation électrique (Vcc) ;
un commutateur (35) connecté en parallèle au premier élément de jonction p-n (33, 34) ;
une deuxième résistance (36) et un deuxième élément de jonction p-n (32) qui sont connectés en série avec le bloc d'alimentation électrique (Vcc) ; et
un moyen de comparaison (31) pour fournir en sortie un signal d'ouverture/fermeture représentant l'état ouvert et fermé du commutateur (35),
dans lequel ledit moyen de comparaison (31) est configuré pour comparer une tension (Vs) d'un premier point de connexion avec une tension (VR) d'un deuxième point de connexion pour fournir en sortie un signal d'ouverture/fermeture, et
les premier et deuxième éléments de jonction p-n sont connectés dans un sens direct relativement à une tension du bloc d'alimentation,
dans lequel
au niveau du premier point de connexion, la première résistance (37), le premier élément de jonction p-n (33,34) et le commutateur (35) sont connectés,
au niveau du deuxième point de connexion, la deuxième résistance (36) et le deuxième élément de jonction p-n (32) sont connectés, et
une chute de tension directe (V_{F}) du deuxième élément de jonction p-n (32) est plus petite qu'une chute de tension directe (2V_{F}) du premier élément de jonction p-n (33, 34).

2. Circuit de détection selon la revendication 1, dans lequel
le deuxième élément de jonction p-n (32) comprend une diode, et
le premier élément de jonction p-n (33,34) comprend une pluralité de diodes qui sont connectées en série.
